Europäisches Patentamt

European Patent Office

Office européen des brevets

(19)

(11) Publication number: **0 066 461**
**A2**

(12) **EUROPEAN PATENT APPLICATION**

(21) Application number: **82302746.1**

(22) Date of filing: **27.05.82**

(51) Int. Cl.³: **H 01 L 21/302**

(30) Priority: **29.05.81 JP 81047/81**

(43) Date of publication of application:
**08.12.82 Bulletin 82/49**

(84) Designated Contracting States:
**DE FR GB NL**

(71) Applicant: **Hitachi, Ltd.**
**5-1, Marunouchi 1-chome**
**Chiyoda-ku Tokyo 100(JP)**

(72) Inventor: **Watanabe, Kikuo**
**2-32-D404, Koyasu-cho**
**Hachioji-shi Tokyo(JP)**

(72) Inventor: **Takano, Yukio**
**5-62-16, Inadaira**
**Musashimurayama-shi Tokyo(JP)**

(72) Inventor: **Takemoto, Iwao**
**2196-458, Hirai Hinodemachi**
**Nishitama-gun Tokyo(JP)**

(72) Inventor: **Kishino, Seigo**
**881-7, Narahara-cho**
**Hachioji-shi Tokyo(JP)**

(74) Representative: **Jackson, John Timothy et al,**
**MEWBURN ELLIS & CO. 2/3 Cursitor Street**
**London EC4A 1BQ(GB)**

(54) **Semiconductor wafer and method of manufacturing the same.**

(57) A semiconductor wafer which has a denuded (oxygen reduced) zone about 5 - 100 μm thick and in which a defect underlying the denuded zone consists essentially only of stacking faults, and a method of manufacturing the same are disclosed.

By heat-treating the semiconductor wafer at a predetermined temperature (1050 - 1150°C), essentially only stacking faults are formed in the inner part of the wafer, and a far better gettering effect than in the prior art can be attained.

EP 0 066 461 A2

SEMICONDUCTOR WAFER AND METHOD OF

MANUFACTURING THE SAME

The present invention relates to a semiconductor wafer and a method of manufacturing the same. More particularly, it relates to a semiconductor wafer which has a high gettering effect and is very useful for forming various semiconductor devices, and a method of manufacturing the same.

As is well known, various semiconductor devices including integrated circuits, solid-state imaging devices, etc. are formed in surface regions of single-crystal silicon wafers.

The silicon wafer is formed from a single-crystal silicon rod grown by the Czochralski method or the like, which is sliced into thin discs (having a thickness of approximately 0.2 - 0.8 mm). A damaged layer is induced by the slicing and is removed by lapping and etching.

When crystal defects or harmful impurities exist within the surface region of the silicon wafer thus formed, the characteristics of the semiconductor device subsequently formed therein are poor. Therefore, various methods for removing the crystal defects and the harmful impurities within the surface region have been proposed.

A most useful process is called "gettering", in which the crystal defects or impurities within the front surface region are transferred to the inner part or rear surface region of the silicon wafer so they have no influence on the characteristics of the semiconductor device, thereby to eliminate the defects or impurities from the front surface region.

One gettering process which has heretofore been practised, for example, is a method in which a high concentration of phosphorus is diffused or a high concentration of argon is implanted into the rear surface region of the silicon wafer, whereupon the wafer is heated.

When phosphorus is diffused into the rear surface of the silicon wafer at a high concentration, the difference between the radii of the atoms of silicon and phosphorus gives rise to a lattice deformation and also to a dislocation network in the rear surface region of the silicon wafer.

When such a silicon wafer having a deformation or dislocation network in its rear surface region is heat-treated, the atoms of the harmful impurities within the front surface region diffuse in the silicon wafer and gather into the area of the deformation in the rear surface region. As a result, the harmful impurities are removed from the front surface region, and also the generation of crystal defects is prevented.

The mechanism of gettering based on the implantation of argon ions is essentially the same as that of the gettering based on the diffusion of phosphorus.

When the argon ions are implanted into the rear surface of the silicon wafer, a crystal deformation appears in the implanted region. As explained above, therefore, the atoms of the harmful impurities within the front surface region can be gathered into the area of deformation in the rear surface region by the heat treatment so as to render the front surface region nondefective.

On the other hand, it has been reported that precipitates (for example, $SiO_2$) existing in a silicon wafer and dislocations resulting therefrom exhibit a gettering action (T.Y.Tan, et al., "Applied Physics Letters", 30, 175 (1977)).

Unlike the foregoing method in which ion implantation or diffusion is performed, this reported method makes precipitates of interstitial oxygen intrinsically contained in the silicon wafer and executes the gettering of the harmful impurities owing to the dislocation generated by the precipitate. It is therefore called "intrinsic gettering", and active researches are being made thereon.

The aforementioned gettering methods, however, have had such disadvantages as complicated processing and insufficient gettering effect. Therefore, it has been difficult to form with a high yield silicon wafers for solid-state imaging devices and large-scale integrated circuits, for which a very high quality is required.

The present invention, at least in some aspects, forms substantially only stacking faults in a silicon wafer by heat-treating the silicon wafer at a predetermined temperature and performs intrinsic gettering by utilising the stacking faults.

More particularly, one aspect of the present invention provides a semiconductor wafer having a denuded zone which is formed within a front surface region in which a device is to be formed, and a defect beneath the denuded zone; characterised in that said denuded zone is approximately 5 - 100 µm thick and that the defect consists substantially of stacking faults.

Another aspect of the present invention provides a method of manufacturing a semiconductor wafer comprising:

(1) the step of heat-treating an initial semiconductor wafer, to remove oxygen contained within the front surface region of said initial semiconductor wafer and to form an oxygen reduced region therein,

(2) the step of heat-treating the resultant semiconductor wafer, to form a nucleus of a crystal defect beneath said oxygen reduced region, and

(3) the step of heat-treating the resultant semiconductor wafer, to form substantially only stacking faults beneath said oxygen reduced region and to perform gettering by said stacking faults.

As is well known, a silicon wafer for use in the formation of various semiconductor devices including large-scale integrated circuits etc. is formed by slicing into a thin disc a silicon rod produced by the Czochralski method.

The Czochralski method is well known, and is a method wherein silicon is molten in a quartz crucible and a seed crystal is slowly pulled up in contact with the silicon melt, thereby to grow single-crystal silicon.

Accordingly, oxygen in the quartz ($SiO_2$) of which the crucible is made cannot be prevented from entering the silicon melt in the course of growing the single crystal. As a result, the single-crystal silicon produced contains supersaturated interstitial oxygen.

The prior-art intrinsic gettering method makes precipitates of the interstitial oxygen as $SiO_2$ within the silicon wafer by a heat treatment, and carries out another heat treatment so as to effect gettering by the dislocations generated from the precipitate.

With the prior-art gettering, however, the removal of defects from the front surface region of the silicon wafer has been insufficient, and it has been difficult to employ the resulting silicon wafer for the formation of solid-state imaging devices etc.

The present invention has been made on the basis of the discovery that the insufficiency of the gettering effect is due to the performance of gettering utilising dislocations generated by the precipitate. In the practice of the invention, heat-treatment conditions are set into predetermined ranges, thereby to form a denuded zone having no crystal defects of a predetermined thickness and to perform gettering with only stacking faults, not with dislocations generated from precipitates.

The preferred method comprises three steps to be described hereunder.

The first step is that oxygen contained in the front surface region of a silicon wafer in which a device is to be formed is volatilised out by a heat treatment in an inert gas, to form an oxygen reduced region approximately 5 - 100 μm

thick within the front surface region.

More specifically, first of all, a single-crystal silicon rod formed by the Czochralski method or the like is sliced into a disc having a thickness of approximately 0.2 - 0.8 mm, whereupon a damaged layer in the front surface of the disc which appears in the slicing is removed by a well known expedient such as mechanical-chemical etching.

Subsequently, the heat treatment is carried out at a temperature of about 1000 - 1200°C in an inert gas such as nitrogen, argon and helium. Thus, oxygen contained in the front surface region of the disc-like silicon wafer is volatilised out to form an oxygen reduced region approximately 5 - 100 μm thick,

When the thickness of the oxygen reduced region is smaller than approximately 5 μm, some stacking faults existing in the inner part of the wafer can appear in the front surface region. When the thickness is greater than 100 μm, it is feared that the gettering effect utilising the stacking faults will become insufficient, resulting in inferior characteristics of the front surface region. For such reasons, the thickness of the oxygen reduced region to to formed in this step should preferably be approximately 5 - 100 μm.

The thickness of the oxygen reduced region formed in this step is determined by the conditions of the heat treatment. By way of example, when a heat treatment at 1200°C for 16 hours is conducted, an oxygen reduced region 50 μm thick is formed, and when a heat treatment at 1000°C for 30 minutes is conducted, an oxygen reduced region 5 μm thick is formed.

If the temperature is held constant, the thickness of the oxygen reduced region formed is substantially proportional to the square root of the heat treatment time. It is therefore easy to control the thickness of the oxygen reduced region to a desired value. However, when the heat treatment temperature is below about 1000°C, the outward volatilisation of oxygen is not readily performed, and when it is above 1200°C, problems concerning the processing equipment such as the breakdown of the reaction tube and warping of the Si wafer are liable to occur. Therefore, the heat treatment temperature in this step should preferably be set at about 1000 - 1200°C.

The second step is the step of forming the nuclei of defects from the interstitial oxygen within the silicon wafer.

More specifically, when the first step is followed by a heat treatment at a temperature of about 600 - 1000°C, the migration of the interstitial oxygen begins, and the defect nuclei are formed. In this step, when the heat treatment temperature is below about 600°C, little migration of the interstitial oxygen takes place, so that it is difficult to form defect nuclei. On the other hand, when it is above about 1000°C, the degree of supersaturation of the interstitial oxygen lowers, so that the formation of defect nuclei becomes difficult.

Accordingly, the temperature of the heat treatment in this step should preferably be set at about 600 - 1000°C. Preferably the heat treatment time is set at about one hour or more, and a heat treatment for a long period of time does not form any hindrance.

The third step is the step of forming stacking faults within the silicon wafer by a heat treatment.

More specifically, heat treatment at a temperature of about 1050 - 1150°C is carried out after the silicon wafer has been treated by the first and second steps. Then, beneath the oxygen-reduced region in the silicon wafer which has been formed by the first step, stacking faults are formed in contact with this oxygen-reduced region so as to perform gettering.

The stacking fault signifies a "new lattice plane having a limited area formed by the heat treatment in lattice planes existent originally". It has been discovered that when gettering is performed with such stacking fault, the removal of defects and impurities from the front surface region proceeds very favorably.

It has also been discovered that when other defects, dislocations etc. coexist with the stacking fault, the effect of the gettering lowers drastically. It is therefore possible to attain a very good result when the gettering is performed by forming only stacking faults in the silicon wafer in the third step after the defect nuclei has been formed by the second step.

In order to form only stacking defects, it is important to set the heat treatment temperature in the third step within the predetermined range.

It has been confirmed by observation with an electron microscope that when the heat treatment temperature in the third step is set at about 1050 - 1150°C, substantially only stacking faults are formed, substantially no other defect being formed.

On the other hand, it has been noted that when the heat treatment temperature in the third step is higher or lower than 1050 - 1150°C, not only stacking faults but also precipitates ($SiO_2$) based on the interstitial oxygen are induced, with the result that defects other than the stacking fault or dislocations arise from the precipitate.

When the stacking fault accompanies other defects or dislocations, the gettering effect based on the stacking fault is conspicuously reduced. It is therefore necessary that the heat treatment in the third step is conducted at about 1050 - 1150°C so as to prevent the occurrence of the other defects, whereupon gettering is performed.

Table 1 compares the characteristics of three kinds of silicon wafers subjected to gettering operations by methods different from one another.

In Table 1, the silicon wafer A is a wafer which was formed by only the foregoing steps 2 and 3 without performing the step 1. The second step was carried out by a heat treatment at 1000°C for 8 hours in an oxygen atmosphere, and the third step by a heat treatment at 1200°C for 3 hours in the oxygen atmosphere.

The silicon wafer B was formed by adding the step 1 for forming a denuded zone, to the aforementioned method for forming the silicon wafer A. As the step 1, a heat treatment at 1200°C for 16 hours was performed in a nitrogen atmosphere, to form a denuded zone approximately 50 μm thick. The second and third steps were carried out under the same conditions as those for preparing the silicon wafer A.

The silicon wafer C was formed according to the present invention. The same method as in the case of the wafer B was employed except that the heat treatment temperature in the step 3 was 1100°C.

Using the silicon wafers A, B and C thus prepared, solid-state imaging devices were formed by the well known MOS process (refer to, for example, "IEEE Transactions on Electron Devices", August 1980, pp. 1676-1681, or "IEEE Transactions on Electron Devices", Vol. ED-27, No.8, August 1980, pp. 1682-1687). Comparisons were made on the densities of defects appearing in the substrates of these devices and on the numbers of white blemishes (image defects) on the screen of a monitor television.

TABLE 1

| Silicon Wafer | Thickness of Denuded Zone (μm) | Bulk Defect * | Bulk Defect Density (cm$^{-3}$) | Surface Defect Density (cm$^{-2}$) | White Blemishes |
|---|---|---|---|---|---|
| A | 0 | SF + P + D | approx. $10^5$ | 3000 | 60 |
| B | approx. 60 | SF + P + D | $6 \times 10^7$ | 60 | 4 |
| C | approx. 50 | SF | $3 \times 10^7$ | 0 | 0 |

\* SF: Stacking Fault,    P: Precipitate,    D: Dislocation

As apparent from Table 1, the silicon wafer A for which the step 1 was not performed and which was not formed with the oxygen reduced region has a very large number of both surface defects and white blemishes. Of course, it is quite unusable.

Although the silicon wafer B has the denuded zone, it includes precipitates and dislocations ascribable thereto besides stacking faults, and hence, its surface defect density is considerably high. Four white blemishes were also noted.

With white blemishes on a television screen, the quality of the picture degrades drastically. In order to put the imaging device into practical use, therefore, practically no white blemishes are allowed on the screen. The silicon wafer B which has four white blemishes cannot be put into practical use.

The silicon wafer C formed by the present invention contains only stacking faults though the bulk defect density is somewhat lower than in the silicon wafer B. Therefore, it exhibited a very excellent gettering effect, and both the surface defect density and the number of white blemishes thereof were zero.

As apparent from the foregoing description, an extraordinarily good gettering effect can be attained, and far better silicon wafers than those produced by the prior-art methods can be manufactured.

For the sake of convenience, the effect of the present method has been described in connection with a solid-state imaging device. Needless to say, however, the present invention is also very useful for the formation of other large-scale integrated circuits of extremely high packaging density.

In the present method, the step 1 is to volatilise out oxygen contained in the front surface region. It is therefore favourable to denude the front surface region of the wafer and to heat the wafer in a non-oxidising atmosphere in order to prevent oxidation of the front surface.

The steps 2 and 3 need not volatilise oxygen. Therefore, the front surface may be covered or be left uncovered. Either an oxidising or non-oxidising gas may be used as the heating atmosphere.

The steps 1, 2 and 3 may be performed as steps which are respectively independent. Needless to say, however, they may well be performed jointly with various steps for forming a semiconductor device, for example, the steps of oxidation and diffusion.

CLAIMS:

1. A semiconductor wafer having a denuded zone which is formed within a front surface region in which a device is to be formed, and a defect beneath the denuded zone; characterised in that said denuded zone is approximately 5 - 100 μm thick and that the defect consists substantially of stacking faults.

2. A method of manufacturing a semiconductor wafer comprising:

(1) the step of heat-treating an initial semiconductor wafer, to remove oxygen contained within a front surface region of said initial semiconductor wafer and to form an oxygen reduced region therein,

(2) the step of heat-treating the resultant semiconductor wafer, to form a nucleus of a crystal defect beneath said oxygen reduced region, and

(3) the step of heat-treating the resultant semiconductor wafer, to form substantially only stacking faults beneath said oxygen reduced region and to perform gettering by said stacking faults.

3. A method of manufacturing a semiconductor wafer as defined in claim 2, wherein the temperature of the heat treatment in said step (1) is about 1000 - 1200°C.

4. A method of manufacturing a semiconductor wafer as defined in claim 2 or 3, wherein the heat treatment in step (I) is conducted in a non-oxidising atmosphere.

5. A method of manufacturing a semiconductor wafer as defined in any one of claims 2 to 4, wherein the temperature of the heat treatment in said step (2) is about 600 - 1000°C.

6.    A method of manufacturing a semiconductor wafer as
defined in any one of claims 2 to 5, wherein the temperature
of the heat treatment in said step (3) is about 1050 - 1150°C.

7.    A semiconductor device formed from a wafer according
to claim 1 or from a wafer produced by a method according to
any one of claims 2 to 6.